# EUROPEAN PATENT SPECIFICATION

(11) **EP 2 804 452 B1**
(45) Date of publication and mention of the grant of the patent: **19.07.2017**
(21) Application number: 14163650.6
(22) Date of filing: 07.04.2014
(51) Int. Cl.: H05K 3/28, H05K 3/36, H05K 1/14, H05K 1/18

(54) **Printed wiring board and board module**
Leiterplatte und Plattenmodul
Carte de circuit imprimé et module

(30) Priority: 14.05.2013 JP 2013102453
(43) Date of publication of application: 19.11.2014
(73) Proprietor: Panasonic Intellectual Property Management Co., Ltd., Osaka-shi, Osaka 540-6207 (JP)
(72) Inventor: IWAO, Seiichi, Chuo-ku, Osaka 540-6207 (JP); ASAKAWA, Koji, Chuo-ku, Osaka 540-6207 (JP); IBUKI, Yasuo, Chuo-ku, Osaka 540-6207 (JP); NISHIMURA, Shinji, Chuo-ku, Osaka 540-6207 (JP); WATANABE, Kazunori, Chuo-ku, Osaka 540-6207 (JP)
(74) Representative: Grünecker Patent- und Rechtsanwälte PartG mbB

(56) References cited:
- EP-A1- 1 694 104
- EP-A2- 1 085 788
- US-A1- 2009 121 346

## Description

The present disclosure relates to a printed wiring board and a board module including the printed wiring board.

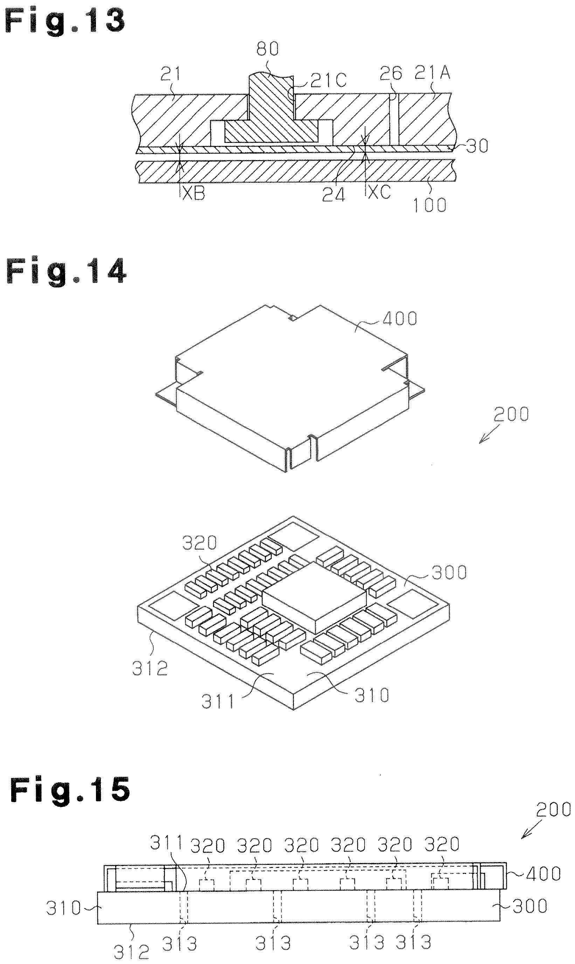

Figs. 14 and 15 illustrate a conventional board module 200. The board module 200 includes a printed circuit board 300 and a case 400. The printed circuit board 300 includes a printed wiring board 310 and electronic components 320. The printed wiring board 310 includes a component mounting surface 311, a board mounting surface 312, and plated through holes 313.

The component mounting surface 311 includes a component-side pattern (not illustrated) electrically connected to the electronic components 320. The board mounting surface 312 includes a board-side pattern. The board-side pattern includes electrode pads to be electrically connected to a control board.

The plated through holes 313, which extend through the printed wiring board 310, electrically connect the component-side pattern and the board-side pattern. The electronic components 320 may be, for example, light emitting diode (LED) chips.

A case 400 is fixed to the printed wiring board 310. Japanese Laid-Open Patent Publication No. 2010-10524 describes a prior art example of a board module.

The board module 200 is mounted on, for example, a control board used in an electronic appliance such as an electric shaver. When the board module 200 is mounted on a control board, openings of the plated through holes 313 in the board mounting surface 312 are opposed to through holes of the control board. When an electric appliance including the board module 200 is used in a wet or humid environment, moisture may enter gaps between the board mounting surface 312 and the control board. The moisture may short-circuit the plated through holes 313 of the board mounting surface 312 with the plated through holes of the control board.

It is an object of the present disclosure to provide a printed wiring board that obviates or limits short-circuiting between a printed wiring board and a control board.

One aspect of the present disclosure is a printed wiring board including a substrate having a component mounting surface and a board mounting surface, which is located at an opposite side of the component mounting surface. A component-side pattern is formed on the component mounting surface. The component-side pattern includes a pad electrically connected to an electronic component. A board-side pattern is formed on the board mounting surface. The board-side pattern includes an electrode pad electrically connected to a control board. The substrate includes a through hole via that electrically connects the component-side pattern and the board-side pattern An insulation sheet is adhered to the board mounting surface of the substrate to cover the through hole via in the board mounting surface.

Other aspects and advantages of the present disclosure will become apparent from the following description, taken in conjunction with the accompanying drawings, illustrating by way of example the principles of the invention.

The invention, together with objects and advantages thereof, may best be understood by reference to the following description of the presently preferred embodiments together with the accompanying drawings in which:
Fig. 1 is a perspective view illustrating one embodiment of a board module and a control board;
Fig. 2 is a rear view of the board module;

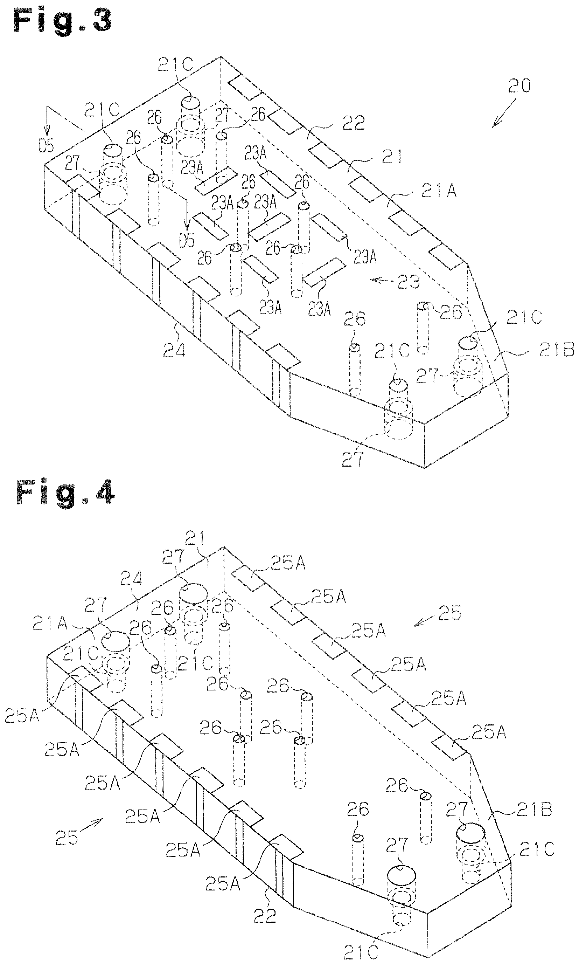

Fig. 3 is a perspective view illustrating a component mounting surface of a printed wiring board;
surface 312 and the control board. The moisture may short-circuit the plated through holes 313 of the board mounting surface 312 with the plated through holes of the control board.

Another prior art document is EP 1085788 A2.

It is an object of the present disclosure to provide a board module that obviates or limits short-circuiting between a printed wiring board and a control board.

One aspect of the present disclosure is a board module according to claim 1.

Other aspects and advantages of the present disclosure will become apparent from the following description, taken in conjunction with the accompanying drawings, illustrating by way of example the principles of the invention.

The invention, together with objects and advantages thereof, may best be understood by reference to the following description of the presently preferred embodiments together with the accompanying drawings in which:

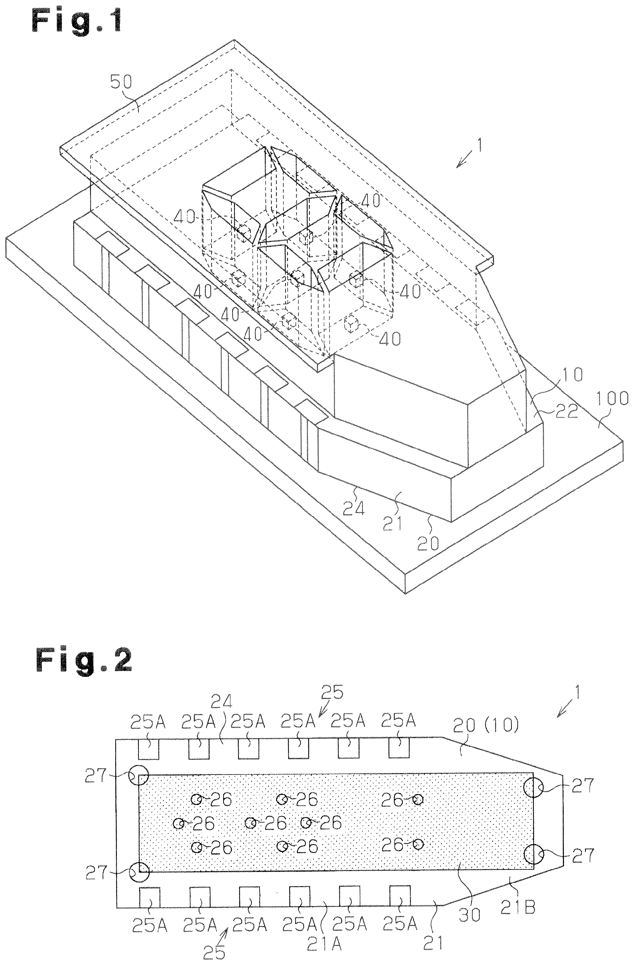

Fig. 1 is a perspective view illustrating one embodiment of a board module and a control board;

pattern (not illustrated) formed on the board mounting surface 24 electrically connects each electrode pad 25A to a predetermined one of the through hole vias 26.

Each through hole via 26 electrically connects the component-side pattern 23 and the board-side pattern 25. In a non-restrictive example, each through hole via 26 has a smaller diameter than each case coupling hole 21C.

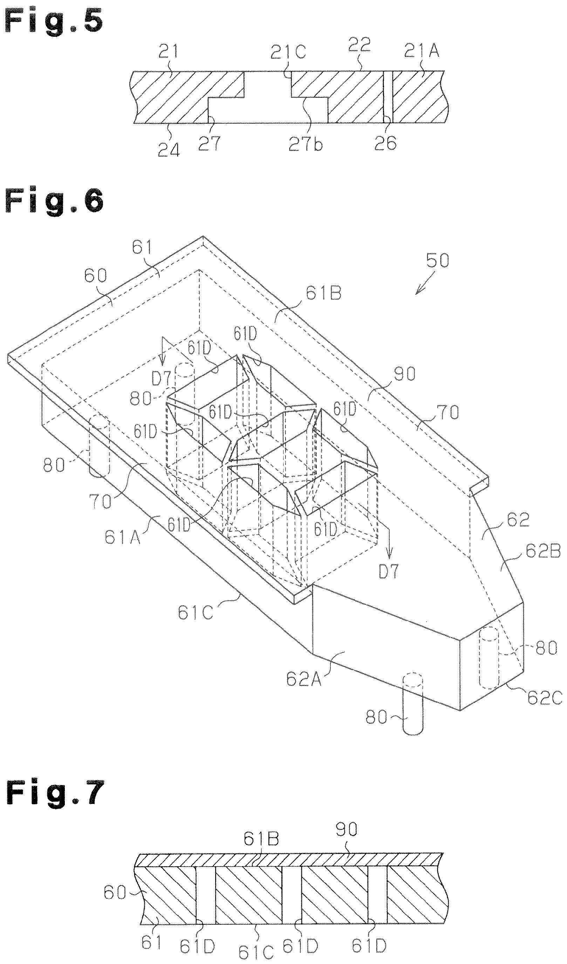

As illustrated in Fig. 5, each recess 27 is located at a position corresponding to one of the case coupling holes 21C. The communication of the recess 27 with the corresponding case coupling hole 21C forms a step 27b in the substrate 21. The recess 27 may be referred to as an opening of the case coupling hole 21C in the board mounting surface 24.

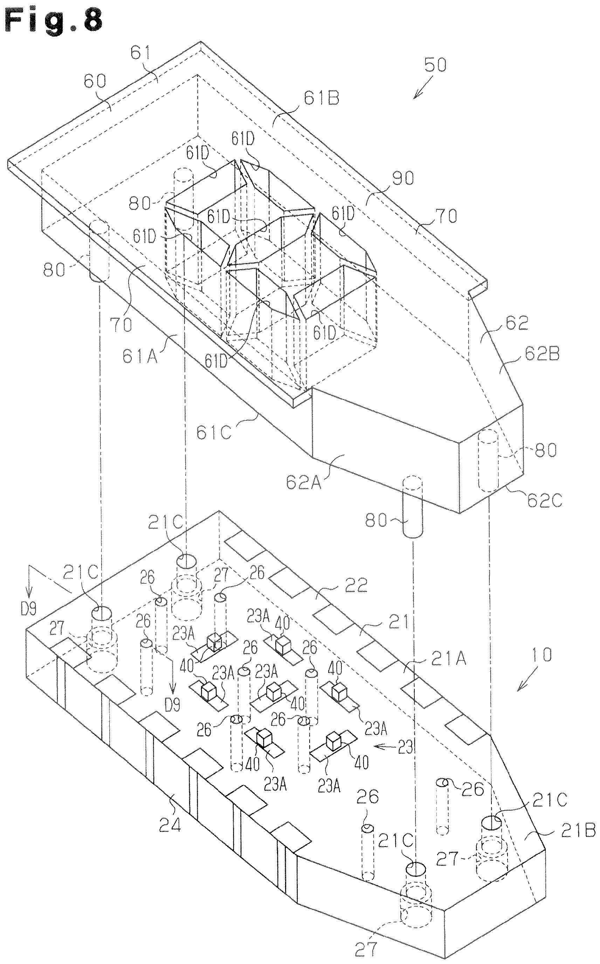

Referring to Fig. 8, the case 50, which is coupled to the component mounting surface 22 of the printed wiring board 20, covers the LED chips 40. The case 50 may be a thermoplastic member. The case 50 includes a main body 60, flanges 70, fastening pins 80, and a sheet 90.

In the illustrated example, the main body 60 includes a box-shaped portion 61 and a tapered portion 62. The box-shaped portion 61 includes side surfaces 61A, an upper surface 61B, a bottom surface 61C, and a plurality of light guide chambers 61D. Each light guide chamber 61D may be formed in the box-shaped portion 61. The side surfaces 61A are formed continuously with the upper surface 61B and the bottom surface 61C. In the illustrated example, the upper surface 61B functions as a light emitting surface. The side surfaces 61A may be referred to as the side surfaces of the case 50.

Each light guide chamber 61D is shaped in conformance with one of the segments in the seven-segment display component. The light guide chamber 61D opens in the upper surface 61B and the bottom surface 61C. When the case 50 is coupled to the printed circuit board 10, each of the seven light guide chambers 61D accommodates one of the LED chips 40.

The tapered portion 62 is formed integrally with the box-shaped portion 61 from the same material. The tapered portion 62 includes side surfaces 62A, an upper surface 62B, and a bottom surface 62C. The side surfaces 62A are formed continuously with the upper surface 62B and the bottom surface 62C. Further, the side surfaces 62A are formed continuously with the side surfaces 61A of the box-shaped portion 61. The upper surface 62B is formed continuously with the upper surface 61B of the box-shaped portion 61. The bottom surface 62C is formed continuously with the bottom surface 61C of the box-shaped portion 61.

Each flange 70 may be a flat plate extending outward from the corresponding side surface 61A of the box-shaped portion 61.

Two of the fastening pins 80 are formed on the box-shaped portion 61. Each fastening pin 80 projects from the bottom surface 61C. Further, two of the fastening pins 80 are formed on the tapered portion 62. Each fastening pin 80 is cylindrical. The four fastening pins 80 are located at positions corresponding to the case coupling holes 21C of the printed wiring board 20 in the bottom surface 61C of the box-shaped portion 61 and the bottom surface 62C of the tapered portion 62.

As illustrated in Fig. 7, the sheet 90 is applied to the upper surface 61B. The sheet 90 functions to diffuse the light emitted from each LED chip 40 in the corresponding light guide chamber 61D so that the user can recognize the light. The sheet 90 may be formed from a transparent resin sheet of polyethylene terephthalate or the like.

A process for manufacturing the board module 1 will now be described with reference to Figs. 8 to 10.

Referring to Fig. 8, in a first step, the printed circuit board 10, which includes the printed wiring board 20 and the LED chip 40, is manufactured. The first step includes soldering the LED chips 40 to the component pads 23A.

Then, in a second step, the case 50 is coupled to the printed circuit board 10. The second step includes inserting the fastening pins 80 into the corresponding case coupling holes 21C.

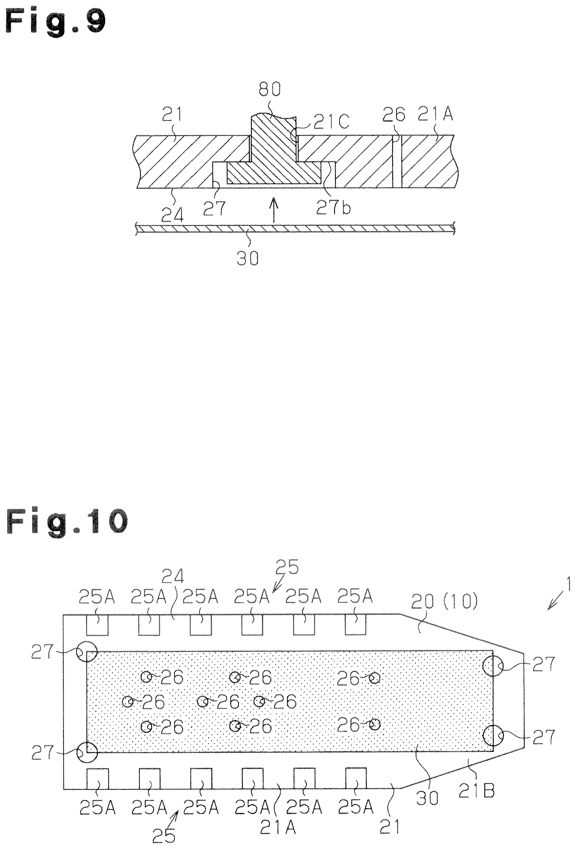

Referring to Fig. 9, in a third step, the distal end of each fastening pin 80 is thermally fused in the corresponding recess 27. The distal end of each fastening pin 80 is engaged with the step 27b. This fixes the case 50 to the printed circuit board 10. In the illustrated example, the distal end of the fastening pin 80 is located in the substrate 21 or substantially flush with the board mounting surface 24. Thus, the fastening pin 80 does not project from the board mounting surface 24.

In a fourth step, the electric insulation sheet 30 is applied to the board mounting surface 24 as illustrated in Fig. 9. In the example illustrated in Fig. 10, the electric insulation sheet 30 covers all through hole vias 26 in the board mounting surface 24 and exposes the electrode pads 25A. The electric insulation sheet 30 may partially or completely cover at least one or all of the recesses 27.

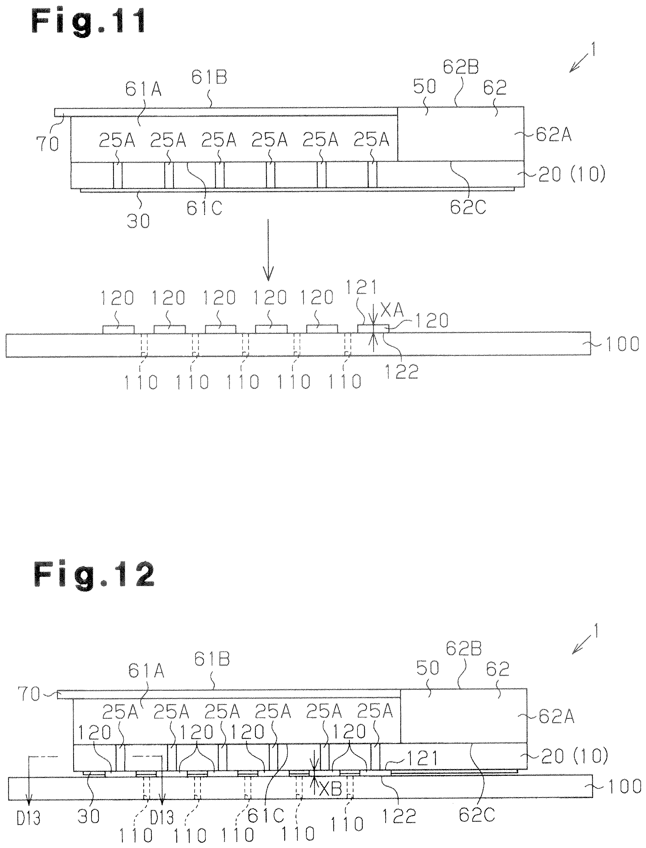

Referring to Figs. 11 to 13, a process for mounting the board module 1 on the control board 100 will now be described.

Referring to Fig. 11, solder 120 is applied to control board 100, which includes the through hole vias 110. The solder 120 has a pre-mounting thickness XA. The solder 120 includes an upper surface 121 facing toward the board module 1 and a lower surface 122 contacting the control substrate 100.

Referring to Fig. 12, the board module 1 is soldered to the control board 100. Each electrode pad 25A of the board module 1 is bonded to the corresponding electrode pad 25A. This electrically connects the board module 1 to the control board 100. After the board module 1 is mounted on the control board 100, the solder 120 has a post-mounting thickness XB, which is less than the pre-mounting thickness XA.

Referring to Fig. 13, the lowermost portion of the printed wiring board 20 is separated from the lower surface of the substrate 21 by distance XC, which is less than the post-mounting thickness XB.

The present embodiment has the advantages described below.
(1) The printed wiring board 20 includes the electric insulation sheet 30, which is joined with the board mounting surface 24 of the substrate 21 to covers the through hole vias 26 in the board mounting surface 24. This obviates or limits short-circuiting of the through hole vias 26 with the control board 100 mounted on the board mounting surface 24.
(2) When soldering the LED chips 40 to the component pads 23A (Fig. 8), the printed wiring board 20 may be exposed to high temperatures. The electric insulation sheet 30 of the printed wiring board 20 is formed from a material including polyimide and has a relatively superior heat resistance. Thus, even when the printed wiring board 20 is exposed to a relatively high temperature, thermal deformation and burning of the electric insulation sheet 30 is obviated or reduced.
(3) For example, in a comparative example that uses a fastener such as a hook to fasten a case to a printed wiring board, a relatively large gap would be formed between the case and the printed wiring board. Thus, moisture may enter the gap and short-circuit a component-side pattern. In contrast, the present embodiment inserts the fastening pins 80 of the case 50 into the case coupling holes 21C of the printed wiring board 20 from the component mounting surface 22 to fix the case 50 to the printed wiring board 20. This fastening structure obviates or limits the formation of a gap between the printed wiring board 20 and the case 50. As a result, the entrance of moisture into the board module 1 between the printed wiring board 20 and the case 50 is obviated or limited, and short-circuiting of the component-side pattern 23 is obviated or limited.
(4) The distal end of each fastening pin 80 of the case 50 is located in the substrate 21 or substantially flush with the board mounting surface 24. Thus, the fastening pin 80 does not project from the board mounting surface 24. Also, the electric insulation sheet 30 covering the fastening pin 80 does not deform to locally project from the board mounting surface 24 at the location corresponding to the fastening pin 80. This allows for a reduction in the distance XC between the lowermost portion of the printed wiring board 20 and the lower surface of the substrate 21.
(5) When a gap is formed at the boundary of the printed wiring board 20 and the case 50, the light emitted from an LED chip 40 may leak out of the case 50 from the side surfaces 61A as the light passes through the gap. The intensity of the leaking light increases at locations closer to the LED chip 40. The board module 1 is mounted on the control board 100 of, for example, an electric shaver. The board module 1, excluding the light emitting surface, is surrounded by the case of the electric shaver. In this case, the leaking light may be visible by the user through a gap between the board module 1 and the case of the electric shaver. In this regard, the case of the present embodiment 50 includes the flanges 70 that extend outward from the side surfaces 61A. The flanges 70 block the leaking light at a location near the LED chip 40. This obviates or limits the recognition of such light having high intensity by the user.

It should be apparent to those skilled in the art that the present invention may be embodied in many other specific forms without departing from the spirit or scope of the invention. Particularly, it should be understood that the present invention may be embodied in the following forms.

Preferably, the electric insulation sheet 30 covers all through hole via 26 in the board mounting surface 24. However, the electric insulation sheet may be applied to the board mounting surface 24 to cover at least one of the through hole vias in the board mounting surface 24

The recesses 27 in the printed wiring board 20 may be omitted. In such an example, the distal end of each fastening pin 80 may be exposed from the board mounting surface 24 when the case 50 is coupled to the printed wiring board 20. It is thus preferable that the distance XC between the lowermost portion of the printed wiring board 20 and the lower surface of the substrate 21 be less than the post-mounting thickness XB.

Each case coupling hole 21C extends through the substrate 21 and includes an opening in the component mounting surface 22 and an opening in the board mounting surface 24. However, the case coupling hole 21C does not need to extend through the substrate 21 as long as the case coupling hole 21C includes an opening in at least the component mounting surface 22. In such an example, each fastening pin 80 of the case 50 is inserted into the corresponding case coupling hole from the component mounting surface 22 and engaged with the substrate 21.

The distal end of each fastening pin 80 may be engaged with the substrate 21 through a process other than thermal fusing such as high-frequency welding or ultrasonic welding. Alternatively, distal end of each fastening pin 80 may be engaged with the substrate 21 by adhering the fastening pin 80 to the substrate 21 with an adhesive, press-fitting the fastening pin 80 into the case coupling hole 21C, or bonding the fastening pin 80 to the substrate 21 using a component such as a hook.

Preferably, the electric insulation sheet 30 is formed from a heat resistant material. However, the electric insulation sheet 30 may be formed from a non-heat resistant material such as a polyester film.

The distal end of each fastening pin 80 is inserted into the corresponding case coupling hole 21C to fix the case 50 to the printed circuit board 10. However, the fastening pins 80 may be omitted from the case 50. In such an example, the case 50 may be fastened to the printed circuit board 10 by a fastener such as a hook.

The case 50 does not have to include the flanges.

The electronic components on the printed circuit board 10 do not have to be the LED chips 40 and may be other electric components, such as a transistor, an integrated circuit, a memory, and a resistor.

The board module 1 is not limited to a seven-segment display device and may be a graphic display device that shows information such as graphics.

The above-described examples (or one or more aspects thereof) may be used in combination with each other. Other embodiments can be used, such as by one of ordinary skill in the art upon reviewing the above description. Also, in the above description, various features may be grouped together to streamline the disclosure. This should not be interpreted as intending that an unclaimed disclosed feature is essential to any claim. Rather, inventive subject matter may lie in less than all features of a particular disclosed embodiment. The scope of the invention is determined by the appended claims.

## Claims

1. A board module (1) including:
a printed wiring board (20), an electronic component (40) and a case (50) wherein:
the printed wiring board (20) comprises:
a substrate (21) including a component mounting surface (22) and a board mounting surface (24), which is located at an opposite side of the component mounting surface (22);
a component-side pattern (23) formed on the component mounting surface (22), wherein the component-side pattern (23) includes a pad (23A) to be electrically connected to an electronic component (40); and
a board-side pattern (25) formed on the board mounting surface (24), wherein the board-side pattern (25) includes an electrode pad (25A) to be electrically connected to a control board (100), wherein the substrate (21) includes a through hole via (26) that electrically connects the component-side pattern (23) and the board-side pattern (25),
the electronic component (40) is electrically connected to the component-side pattern (23) of the printed wiring board (20); and
the case (50) covers the electronic component (40), wherein
the substrate (21) includes a case coupling hole (21 C) that opens in at least the component mounting surface (22), and
the case (50) includes a fastener (80) inserted into the case coupling hole (21 C) from the component mounting surface (22) and engaged with the substrate (21), the board module (1) being **characterized by** an electric insulation sheet (30) adhered to the board mounting surface (24) of the substrate (21) to cover the through hole via (26) in the board mounting surface (24), wherein the electric insulation sheet (30) includes a heat resistant material with a heatproof temperature between 200°C and 400°C.

2. The board module (1) according to claim 1, wherein the case coupling hole (21C) includes an opening (27) in the board mounting surface (24).

3. The board module (1) according to claim 1 or 2, wherein the fastener (80) includes a distal end that is substantially flush with the board mounting surface (24) or located entirely in the substrate (21).

4. The board module according to claim 1, wherein the case coupling hole is a blind hole that includes an opening only in the component mounting surface.

5. The board module according to any one of claims 1 to 4, wherein
the electronic component (40) functions to emit light, and
the case (50) includes an upper surface (61B) that functions as a light emitting surface, a side surface (61A), and a flange (70) that extends outward from the side surface (61A).

## Patentansprüche

1. Ein Plattenmodul (1) aufweisend:
eine Leiterplatte (20), eine elektronische Komponente (40) und ein Gehäuse (50), wobei:
die Leiterplatte (20) aufweist:
ein Substrat (21) inklusive einer Komponentenmontagefläche (22) und einer Plattenmontagefläche (24), die an einer gegenüberliegenden Seite der Komponentenmontagefläche (22) vorgesehen ist,
eine komponentenseitige Anordnung (23), die an der Komponentenmontagefläche (22) geformt ist, wobei die komponentenseitige Anordnung (23) ein Pad (23A) beinhaltet, das elektrisch mit einer elektronischen Komponente (40) zu verbinden ist, und
eine plattenseitige Anordnung (25), die an der Plattenmontagefläche (24) geformt ist, wobei die plattenseitige Anordnung (25) ein elektronisches Pad (25A) aufweist, das elektrisch mit einer Steuerplatte (100) zu verbinden ist, wobei das Substrat (21) ein Durchgangskontaktloch (26) aufweist, das elektrisch die komponentenseitige Anordnung (23) und die plattenseitige Anordnung (25) verbindet,
die elektronische Komponente (40) ist elektrisch mit der komponentenseitigen Anordnung (23) der Leiterplatte (20) verbunden; und das Gehäuse (50) bedeckt die elektronische Komponente (40), wobei das Substrat (21) ein Gehäusekopplungsloch (21C) beinhaltet, das zumindest in die Komponentenmontagefläche (22) öffnet, und das Gehäuse (50) beinhaltet einen Befestiger (80) der in das Gehäusekopplungsloch (21 C) von der Komponentenmontagefläche (22) eingesetzt ist und in das Substrat (21) eingreift, das Plattenmodul (1) ist **gekennzeichnet durch** eine elektrische Isolierschicht (30), die auf der Plattenmontagefläche (24) des Substrats (21) haftet, um das Durchgangskontaktloch (26) in der Plattenmontagefläche (24) zu bedecken, wobei die elektrische Isolierschicht (30) ein wärmeresistentes Material mit einer Hitzebeständigkeitstemperatur zwischen 200°C und 400°C beinhaltet.

2. Das Plattenmodul (1) gemäß Anspruch 1, wobei das Gehäusekopplungsloch (21C) eine Öffnung (27) in der Plattenmontagefläche (24) beinhaltet.

3. Das Plattenmodul (1) gemäß Anspruch 1 oder 2, wobei der Befestiger (80) ein distales Endes aufweist, das im Wesentlichen bündig mit der Plattenmontagefläche (24) ist oder insgesamt in dem Substrat (21) vorgesehen ist.

4. Das Plattenmodul gemäß Anspruch 1, wobei das Gehäusekopplungsloch ein Sackloch ist, das eine Öffnung nur in der Komponentenmontagefläche beinhaltet.

5. Das Plattenmodul gemäß einem der Ansprüche 1 bis 4, wobei die elektronische Komponente (40) als ein Lichtaussender dient, und das Gehäuse (50) eine obere Fläche (61B), die als eine Lichtaussendeoberfläche dient, eine Seitenfläche (61A), und ein Flansch (70), der sich von der Seitenfläche (61A) nach außen erstreckt, beinhaltet.

## Revendications

1. Module de carte (1) incluant :
une carte de câblage imprimée (20), un composant électronique (40) et un boîtier (50),
dans lequel
la carte de câblage imprimée (20) comprend :
un substrat (21) incluant surface de montage de composants (22) et une surface de montage de carte (24) qui est située du côté opposé à la surface de montage de composants (22),
un motif du côté composants (23) formé sur la surface de montage de composants (22), le motif du côté composants (23) incluant une plage (23A) à relier électriquement à un composant électronique (40), et
un motif du côté carte (25) formé sur la surface de montage de carte (24), le motif du côté carte (25) incluant une plage formant électrode (25A) à relier électriquement à une carte de commande (100), le substrat (21) incluant un trou de liaison traversant (26) qui relie électriquement le motif du côté composants (23) et le motif du côté carte (25),
le composant électronique (40) est relié électriquement au motif du côté composants (23) de la carte de câblage imprimée (20), et
le boîtier (50) recouvre le composant électronique (40), dans lequel
le substrat (21) inclut un trou de couplage de boîtier (21C) partant de la surface de montage de composants (22) et en prise avec le substrat (21), le module de carte (1) étant **caractérisé par** une feuille d'isolation électrique (30) collée à la surface de montage de carte (24) du substrat (21) afin de recouvrir le trou de liaison traversant (26) dans la surface de montage de carte (24), la feuille d'isolation électrique (30) incluant un métal résistant à la chaleur présentant une température de résistance à la chaleur comprise entre 200 °C et 400 °C.

2. Module de carte (1) selon la revendication 1, dans lequel le trou de couplage de boîtier (21C) inclut une ouverture (27) pratiquée dans la surface de montage de carte (24).

3. Module de carte (1) selon la revendication 1 ou la revendication 2, dans lequel le moyen d'assemblage (80) inclut une extrémité distale qui affleure sensiblement à la surface de montage de carte (24) ou bien qui est située entièrement dans le substrat (21)

4. Module de carte (1) selon la revendication 1, dans lequel le trou de couplage de boîtier est un trou borgne qui inclut une seule ouverture dans la surface de montage de composants.

5. Module de carte (1) selon l'une quelconque des revendications 1 à 4, dans lequel :
le composant électronique (40) fonctionne pour émettre de la lumière, et
le boîtier (50) inclut une surface supérieure (61B) qui fonctionne comme surface d'émission de lumière, une surface latérale (61A) et une collerette (70) qui s'étend vers l'extérieur depuis la surface latérale (61A).
